# EUROPEAN PATENT APPLICATION

(11) **EP 1 659 703 A1**
(43) Date of publication of application: **24.05.2006**
(21) Application number: 04292727.7
(22) Date of filing: 17.11.2004
(51) Int. Cl.: H04B 1/707

(54) **Method and means for decreasing the peak to average power ratio in mobile phones**

(71) Applicant: ALCATEL, 75008 Paris (FR)
(72) Inventor: Haberland, Bernd, 70186 Stuttgart (DE); Pascht, Andreas, 73635 Rudersberg (DE); Bohn, Thomas, 70176 Stuttgart (DE)
(74) Representative: Kohler Schmid Möbus

(57) **Abstract**

A method for improving the output signal of a mobile terminal, in particular a UMTS mobile terminal, comprises the steps of
a. clipping said signal for decreasing its peak to average power ratio to a predefined threshold;
b. submitting said clipped signal to a power amplifier designed to amplify the clipped signal

Thus, the power amplifier design of the mobile terminal becomes independent of the number of channels used in the digital processing chain of the mobile terminal.

## Description

### Background of the invention

The invention relates to a method for improving the output signal of a UMTS mobile terminal and a mobile terminal designed for implementing the method.

Adding new channels in mobile phones may cause a change in the peak to average power ratio (PAR) of the signal transmitted from a mobile terminal to a base station. For example, due to a new control channel for high speed downlink packet access (HSDPA) in release 5 of the 3GPP specifications (third generation partnership project), the PAR of the signal transmitted from the mobile terminal to the base station is significantly increased compared to the 3GPP release 99. This and the fact that the signal transmitted by the mobile terminal has to fit into a spectrum emission mask defined by 3GPP makes new solutions necessary. For example, the above mentioned problem may lead to a new power amplifier design with a more powerful amplifier or a bigger back -off or an output power decrease of the mobile terminal. Those solutions are either not energy efficient or cell coverage decreasing. Energy efficiency is an important issue for mobile terminal manufacturers; cell coverage for the operators. Therefore, all the discussed solutions are not optimal and until now, there is no agreement in 3GPP.

### Object of the invention

It is the object of the invention to provide a method and mobile terminal for limiting the maximum PAR of the output signal of the mobile terminal.

### Short description of the invention

This object is achieved by a method for improving the output signal of a UMTS mobile terminal comprising the steps of
a) clipping the signal peaks of said signal to a predefined threshold for decreasing its peak to average power ratio;
b) submitting said clipped signal to a power amplifier designed to amplify the clipped signal.

Clipping is a digital signal process, which removes large peaks from the signal with a minimal damage of the signal spectrum. Therefore, PAR of the clipped signal becomes less than the PAR of the unclipped signal with only a minimal or no loss of information. Integrating such signal clipping in the mobile terminal transmitter, the mobile terminal can easily deal with signals having a higher PAR without changing anything within the power amplifier chain. The energy efficiency of the mobile terminals amplifier will stay the same or even become better. This means that additional channels may be added. The power amplifier design becomes independent of the number of channels. Hence, power amplifier design is facilitated.

The inventive method is particularly advantageous in the use of mobile terminals supporting HSDPA, HSUPA (high speed uplink packet access) or any other uplink channels introduced after 3GPP release 99. With the inventive method, the PAR of an analog output signal, which is sent by the mobile terminal, is limited to a maximum PAR. The PAR is the ratio of the instantaneous peak value, i.e. maximum magnitude of a signal parameter, to its time averaged value. According to the invention the peak to average ratio is determined for the signal parameter "power".

In a preferred variant of the method the power of each data sample of the signal is calculated and the signal is clipped if the power is above the predefined threshold. Clipping is the limitation of large power peaks of signals and transmitters with a non constant envelope. In principal, two different kinds of clipping may be used. The first possibility is soft clipping.

In soft clipping, a correction signal power with a predefined bandwidth is subtracted from an input signal power, if the input signal power is above the clipping threshold. This method influences adjacent data samples. However, it does not influence the adjacent channel leakage power ratio (ACLR).

The second possibility is hard clipping. In hard clipping each data sample is limited independently. The input signal power is cut off, if the input signal power reaches the clipping threshold. There is no influence on adjacent samples, however there is an influence on ACLR.

In a preferred variant of the method the clipped signal is filtered prior to being amplified. This has the advantage, that edges are smoothed before amplification. This is particularly advantageous if hard clipping is being used.

Because a mobile terminal is working with only one carrier, single carrier clipping is applied. This is less complex than multi carrier clipping and takes into account the limited resources of a mobile terminal. Single carrier clipping can be derived from the multi carrier base station clipping used in UMTS base station transmitters.

The invention also relates to a mobile terminal comprising a digital signal processing chain, wherein said chain comprises a clipping module for decreasing the peak to average power ratio of a signal to be transmitted to a predefined threshold, said clipped signal being fed to a power amplifier of said mobile terminal, designed for amplifying the clipped signal. The signal clipping becomes part of the mobile terminal digital signal processing chain feeding complex data signals into the digital to analog converter. Since the clipping is also a digital signal processing, it may be integrated in the existing digital signal processing unit. Existing mobile terminal power amplifier designs may be reused for future 3GPP releases, e.g. release 5 mainly with HSDPA as new feature. The inventive mobile terminal has an increased power amplifier efficiency and therefore the energy efficiency of the mobile terminal is increased. Furthermore, the original planned cell coverage may be preserved.

In a preferred embodiment the mobile terminal comprises a filter between the signal processing chain and the power amplifier for filtering the clipped signal. A filtered signal with smoothed edges is easier to amplify.

In a further embodiment of the mobile terminal a digital to analog converter is provided for converting the complex digital signal delivered from the digital processing chain in to a complex analog signal, which is submitted to a mixer. In the mixer the complex analog signal is combined to an analog signal.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawings

The invention is shown in the drawing.
- **Fig. 1**: shows a schematic representation of a mobile terminal transmitter chain from base band to antenna;
- **Fig. 2**: a diagram for explaining clipping;
- **Fig. 3**: a diagram showing soft clipping;
- **Fig. 4**: a diagram showing hard clipping.

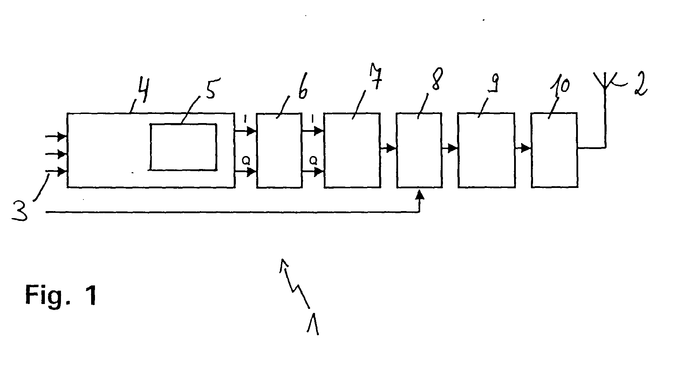

Fig 1 shows a mobile terminal transmitter chain 1 extending from a baseband on the left hand side of the figure to an antenna 2. The arrows 3 represent different channels or codes. If a channel is added, the PAR of the output signal increases. The channels 3 lead to the digital signal processing unit 4 of the mobile terminal. In the digital signal processing unit is integrated a signal clipping module 5 for clipping the digital signal if the power of the digital signal rises above a predefined threshold. The I/Q data, i.e. the real and imaginary part of a data sample are transferred to a digital to analog converter 6. There, the clipped digital signal is converted into an analog signal comprising a real and imaginary part. This analog signal is fed to a mixer 7 and then amplified in a VCO 8. After that, the analog signal is filtered in filter 9 and amplified in power amplifier 10 before being transmitted via antenna 2.

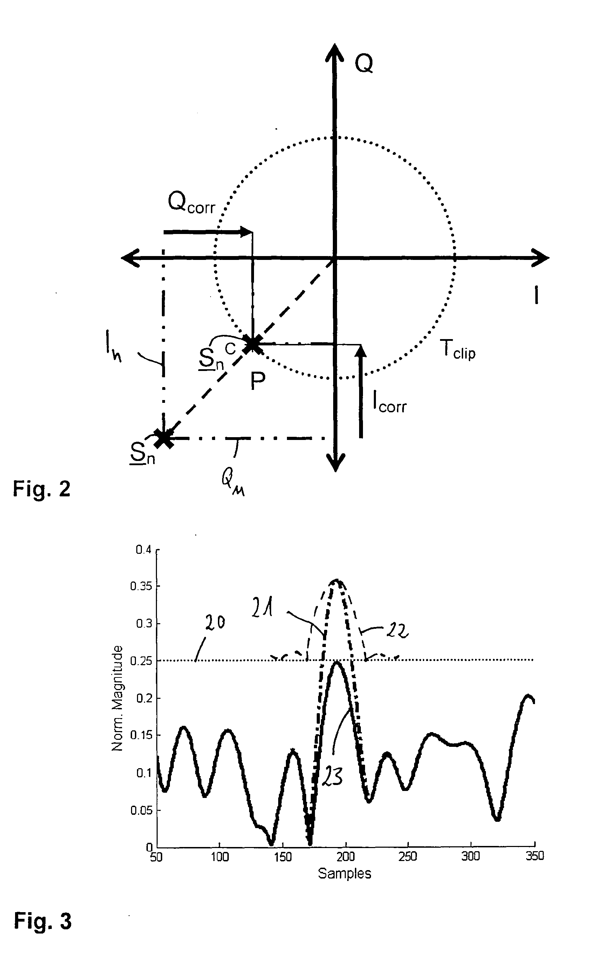

Fig 2 shows a representation of a complex data sample Sₙ, which is part of a digital signal. The data sample Sₙ has a relatively large power P. The power P is larger than the clipping threshold T_{clip}, which is represented by the circle. Clipping is performed by subtracting correction values I_{corr} , Q_{corr} from the data sample Sₙ, e.g. In, Qₙ. Hence, the signal power of the clipped data sample Sₙ^{C} is reduced to the clipping threshold T_{clip}.

Fig. 3 shows a diagram representing soft clipping. The diagram shows a normalized signal power vs. the number of sample. The clipping threshold is represented by line 20. If the input signal power 21 increases above the clipping threshold 20, a correction signal power 22 is subtracted from the input signal power 21. Thus an output signal power 23 is generated which is below or equal to the clipping threshold 20.

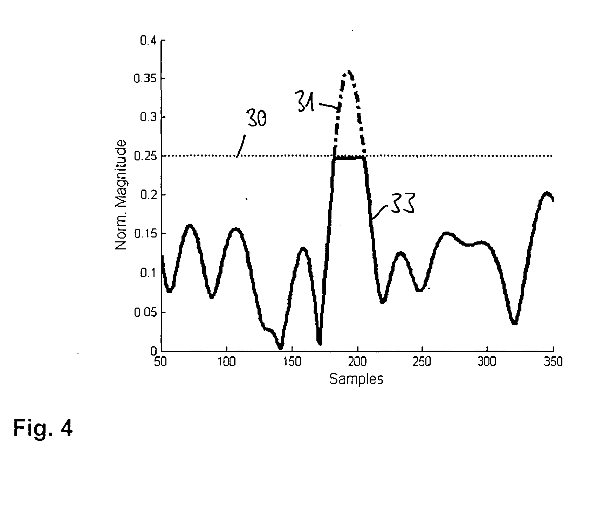

Fig. 4 shows a diagram for explaining hard clipping. The diagram of fig. 4 again shows normalized signal power vs. the number of sample. The line 30 represents the clipping threshold. If the input signal power 31 increases above the clipping threshold 30, the signal is cut off, such that the output signal power 33 is created. For data samples having a normalized signal power below the clipping threshold 30, the input signal power and the output signal power are identical.

A method for improving the output signal of a mobile terminal, in particular a UMTS mobile terminal, comprises the steps of
a. clipping said signal for decreasing its peak to average power ratio to a predefined threshold;
b. submitting said clipped signal to a power amplifier designed to amplify the clipped signal
Thus, the power amplifier design of the mobile terminal becomes independent of the number of channels used in the digital processing chain of the mobile terminal.

## Claims

1. Method for improving the output signal of a mobile terminal, in particular a UMTS mobile terminal, comprising the steps of
a) clipping said signal for decreasing its peak to average power ratio to a predefined threshold;
b) submitting said clipped signal to a power amplifier designed to amplify the clipped signal

2. Method according to claim 1, **characterized in that** the power of each data sample of the signal is calculated and the signal is clipped if the power is above the predefined threshold.

3. Method according to claim 1, **characterized in that** the clipped signal is filtered prior to being amplified.

4. Method according to claim 1, **characterized in that** single carrier clipping is applied.

5. Mobile terminal comprising a digital signal processing chain, **characterized in that** said chain comprises a clipping module for decreasing the peak to average power ratio of a signal to be transmitted to a predefined threshold, said clipped signal being fed to a power amplifier of said mobile terminal designed for amplifying the clipped signal.

6. Mobile terminal according to claim 5, **characterized in that** the mobile terminal comprises a filter between the signal processing chain and the power amplifier for filtering the clipped signal.

7. Mobile terminal according to claim 5, **characterized in that** a digital to analog converter is provided for converting the complex digital signal delivered from the digital processing chain to a complex analog signal which is submitted to a mixer.

## Amended claims

### Amended claims in accordance with Rule 86(2) EPC.

**1.** Method for improving the output signal of a mobile terminal, in particular a UMTS mobile terminal, comprising the steps of
a) clipping said signal for decreasing its peak to average power ratio to a predefined threshold (T_{clip});
b) submitting said clipped signal to a power amplifier (10) designed to amplify the clipped signal;
**characterized in that** the clipped signal is filtered prior to being amplified, and **in that** single carrier clipping is applied.

**2.** Method according to claim 1, **characterized in that** the power of each data sample (Sₙ) of the signal is calculated and the signal is clipped if the power is above the predefined threshold (T_{clip}).

**3.** Mobile terminal comprising a digital signal processing chain, wherein said chain comprises a clipping module (5) for decreasing the peak to average power ratio of a signal to be transmitted to a predefined threshold (T_{clip}), said clipped signal being fed to a power amplifier (10) of said mobile terminal designed for amplifying the clipped signal, **characterized in that** a digital to analog converter (6) is provided for converting the complex digital signal delivered from the digital processing chain to a complex analog signal which is submitted to a mixer (7).

**4.** Mobile terminal according to claim 3, **characterized in that** the mobile terminal comprises a filter (9) between the signal processing chain and the power amplifier (10) for filtering the clipped signal.
